# EUROPEAN PATENT APPLICATION

(11) **EP 3 214 643 A2**
(43) Date of publication of application: **06.09.2017**
(21) Application number: 16195582.8
(22) Date of filing: 25.10.2016
(51) Int. Cl.: H01L 21/56, H01L 21/683, H01L 21/78, H01L 23/31

(54) **OVERMOLDED CHIP SCALE PACKAGE**

(30) Priority: 03.03.2016 US 201615060548
(71) Applicant: Nexperia B.V., 6534 AB Nijmegen (NL)
(72) Inventor: BURMEISTER, Frank, 5656 AG Eindhoven (NL); LEUNG, Chi Ho, 5656 AG Eindhoven (NL); LI, Zhigang, 5656 AG Eindhoven (NL); ZHAO, Yunjun, 5656 AG Eindhoven (NL); KIRCHHEIMER, Karen, 5656 AG Eindhoven (NL); RITTER, Hans-Martin, 5656 AG Eindhoven (NL)
(74) Representative: Crawford, Andrew

(57) **Abstract**

A method of packing a semiconductor device is disclosed. The method includes placing a wafer on a carrier such that a backside of the wafer is facing up and a front side is facing down and non-permanently affixed to the surface of the carrier, performing lithography to mark area to be etched on the backside of the wafer, etching the marked areas from the backside of the wafer thus forming trenches that mark boundaries of individual devices on the wafer, applying a protective coating on the backside of the wafer thus filling the trenches and entire backside of the wafer with a protective compound and cutting the individual devices from the wafer.

## Description

### BACKGROUND

Ever decreasing size of electronic systems demands smaller and thinner electronic components. An electronic component such as an integrated circuit typically uses a small piece of silicon wafer. However, its final size becomes much bigger after packaging and adding pins. Solder balls are increasingly being used on the bottom of integrated circuits or even discrete components to replace conventional metal pins. However, to improve system reliability, a semiconductor component (e.g., an integrated circuit) still needs to be packaged to provide sidewall protection and preventing cracks.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

In one embodiment, a method of packing a semiconductor device is disclosed. The method includes placing a wafer on a carrier such that a backside of the wafer is facing up and a front side is facing down and non-permanently affixed to the surface of the carrier, performing lithography to mark area to be etched on the backside of the wafer, etching the marked areas from the backside of the wafer thus forming trenches that mark boundaries of individual devices on the wafer, applying a protective coating on the backside of the wafer thus filling the trenches and entire backside of the wafer with a protective compound and cutting the individual devices from the wafer after the protective overmold is cured. In some embodiments, method steps are performed in sequentially in the listed order.

In another embodiment, a semiconductor device packaged using an operation on a backside of a wafer is disclosed. The operation includes placing a wafer on a carrier such that a backside of the wafer is facing up and a front side is facing down and non-permanently affixed to the surface of the carrier, performing lithography to mark area to be etched on the backside of the wafer, etching the marked areas from the backside of the wafer thus forming trenches that mark boundaries of individual devices including the semiconductor device on the wafer, applying a protective coating on the backside of the wafer thus filling the trenches and entire backside of the wafer with a protective compound, and cutting the semiconductor device from the wafer.

In some embodiments, the methods described above further include removing the individual devices from the carrier. The carrier may be a sticky foil or a buffer wafer or a combination thereof. The front side of the wafer includes a solder pad. The front side of the wafer, except the solder pad, is covered with an isolation layer. The etching includes removing the portions of the isolation layer such that the depth of the trenches is substantially the same as the thickness of the wafer. In some embodiments, the lithography to mark areas uses non-linear lines to mark the boundaries and the etching results in the individual devices with grooves on sidewalls. The protective coating uses a non-conductive material with adhesive and reasonably non-brittle (so as not to break during normal handling and use of the device it encloses) characteristics. In some embodiments, the lithography and the etching further includes marking and etching area under the solder pad and the protective coating fills the area under the solder pad with the protective compound. In some embodiments, the lithography and the etching further includes dividing each of the individual devices into two or more active regions separated by a dividing trench and the protective coating fills the dividing trench with the protective compound.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments. Advantages of the subject matter claimed will become apparent to those skilled in the art upon reading this description in conjunction with the accompanying drawings, in which like reference numerals have been used to designate like elements, and in which:
FIG. 1a depicts a schematic of a wafer mounted on top of a carrier in accordance with one or more embodiments of the present disclosure;
FIG. 1b depicts a schematic of a wafer showing a solder pad and interconnects in accordance with one or more embodiments of the present disclosure;
FIG. 2 illustrates the wafer after trenches are formed in the backside of the wafer in accordance with one of more embodiments of the present disclosure;
FIG. 3 is a plan view of a section of the backside of the wafer after tranches are formed in accordance with one of more embodiments of the present disclosure;
FIG. 4 depicts the wafer after molding compound is deposited on the backside of the wafer in accordance with one of more embodiments of the present disclosure;
FIGS. 5a, 5b, 5c depict an individual devices cut out from the wafer after depositing mold compound on the backside of the wafer in accordance with one of more embodiments of the present disclosure;
FIG. 6 depicts grooves on sidewalls of devices on the wafer after trenches are formed in the backside of the wafer in accordance with one of more embodiments of the present disclosure;
FIG. 7 is a plan view of a section of the backside of the wafer showing grooves in sidewalls in accordance with one of more embodiments of the present disclosure;
FIG. 8 shows a cross section of a device on the wafer in which active material is removed from under the solder pads in accordance with one of more embodiments of the present disclosure;
FIG. 9 shows a cross section of a device on the wafer in which active material is removed from under the solder pads and solder pads are connected with active regions using interconnects in accordance with one of more embodiments of the present disclosure;
FIG. 10 is a plan view of a section of the backside of the wafer showing active material removed under solder pads in accordance with one of more embodiments of the present disclosure;
FIG. 11 depicts a device on the wafer in which the active region is separated in accordance with one or more embodiments of the present disclosure;
FIG. 12 is a plan view of a section of the backside of the wafer showing active material separated in accordance with one of more embodiments of the present disclosure; and
FIG. 13 is a plan view of a device showing isolation regions in accordance with one or more embodiments of the present disclosure.

Note that figures are not drawn to scale. Intermediate steps between figure transitions have been omitted so as not to obfuscate the disclosure. Those intermediate steps (e.g., applying photoresist) are known to a person skilled in the art.

### DETAILED DESCRIPTION

Systems being built today are much smaller than before when factoring features and computing power they offer. More and more components are being packed into these small products year after year. The number of components in per unit area on a semiconductor wafer have also been going up year after year. It is well known that a plurality of same devices is formed on a semiconductor wafer and then each of these devices are cut from the wafer and packaged into a plastic like cover to protect the delicate device inside. Pins are added prior to packaging to provide a way for an external circuit to connect with the device inside the package. The packaging and pins increase the overall size of the device substantially. Technologies have been developed to replace pins with solder balls on the bottom of a device. However, having these solder balls attached to the bottom of a device creates issue because normal packaging technologies can no longer be used. Further, if the device is used on a system board without packaged, the issues relating to sidewall isolation/protection and preventing cracks become prominent. Further, since the device size may be very small it is desirable that the packaging process must be completed prior to cutting these devices from the wafer because it may be expensive to develop special machines that can handle all sizes of devices individually without damaging them during packaging steps while providing high yield. As it will be apparent from the following description, it is cheaper and more reliable to package the devices prior to cutting them out of the wafer. It will also be apparent from the following description that the methods described herein can be accomplished using the same technologies and processes that are used for device fabrication. Further, devices on the entire wafer can be packaged simultaneously, thus providing high yield and reducing overall cost.

Conventionally, as described in "Encapsulated Wafer Level Pack Technology (eWLCS)" by Tom Strothmann, IEEE 2014, the wafer is diced prior to the wafer level packaging process. The dice are then reconstituted into a new wafer form with adequate distance between the die to allow for a thin layer of protective coating to remain after final singulation. This process is prone to defects as it is difficult to handle small dies and to ensure uniform distance between dies during the reconstruction of the new wafer. This prior art process also require process steps (e.g., reconstruction of the new wafer from a plurality of dies) that are not used in standard semiconductor fabrication process. Further, since the protective coating is applied from the active side of the wafer, the prior art process requires protecting solder pads prior to the application of the protective coating. The methods described herein do not require singulation of dies prior to the application of a thin protective coating and since the process of applying the protective coating is performed from the backside of the wafer, the protection of solder pads is not needed.

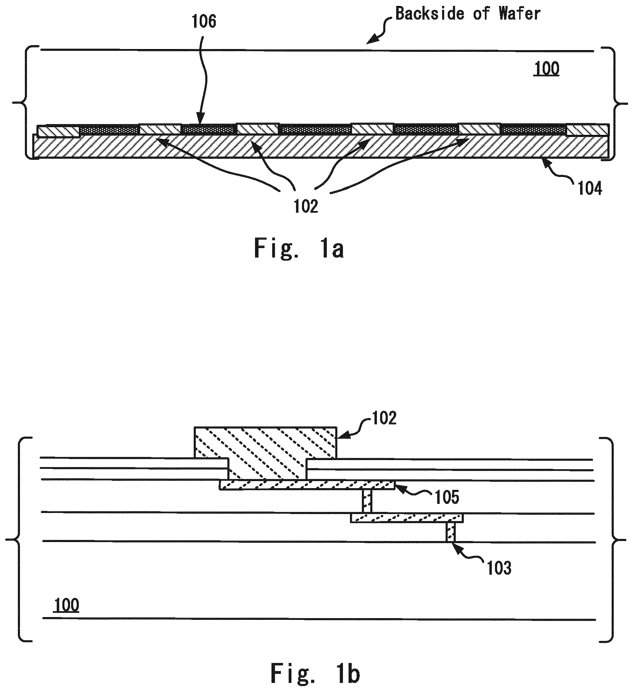

FIG. 1a depicts a schematic of a wafer 100 placed on top of a mechanically stable carrier 104. The carrier 104 may consist of a stack of materials, for example, a sticky foil and a buffer wafer. The wafer 100 is placed active side down on the carrier 104. In some embodiments, the wafer 100 has been processed through circuit fabrication process to fabricate a desired circuit on the wafer 100. It should be noted that typically multiple copies of the same circuit or device are repeated on the wafer 100 to make multiple such devices in one group of fabrication process step. The number of devices on the wafer may depend on the area occupied by the device on the wafer 100 and the size of the wafer 100. In some embodiments, the wafer 100 is processed to fabricate desired types of discrete semiconductor components. The methods described herein are applicable in the manufacturing of both discrete components and integrated circuits. After the wafer 100 is processed to fabricate devices using well known process steps, solder pads 102 are mounted at desired places on the wafer 100 based on the circuit design of the devices fabricated on the wafer 100.

Conventionally, after devices are fabricated on the wafer 100, the devices are cut out of the wafer 100 through mechanical means and individual devices are sent for packaging. However, in the methods described here, the process of cutting the devices out of the wafer 100 is deferred until each device is protected using a protective overmold.

The solder pads 102 are typically formed on a metal contact made of aluminum-silicon alloy. However, other metals or alloys may be used so long as they provide good conductivity and adhesion to the surface of the wafer 100. The metal contact is covered by a protective layer (e.g., a layer of Si3N4 or SiO2). Through wet or dry etching, a hole is exposed through the protective layer such that the metal contact is at least partially exposed. A layer of a compound such as polymide is then placed on the entire surface and the metal contact is again exposed through etching. A metallization layer is then formed, typically through sputtering, on the wafer 100 that covers all entire wafer 100 including the exposed metal contact. The seed metallization layer is typically made of Titanium Tungsten Alloy (TiW). Other metals or alloys may be used so long as they provide a same or similar adhesive, mechanical and conductive characteristics as TiW. On the seed metallization layer, another metal layer is formed. The second metal layer is typically made of Gold, Palladium, Copper, Nickel, Aluminum or a combination thereof. Subsequently, a thick film resist layer is placed and through etching, the area above the metal contact is exposed leaving a well above the metal contact. The well is then filled with a metal having good mechanical and conductive properties such as copper and then a layer of another metal such as Tin (Sn) is placed over it. Photoresist layer is stripped and seed metal layer(s) are etched, preferably using the wet etch process.

FIG. 1b shows a solder pad 102 and interconnects 105 going through various insulation layers such as silicon nitride layer silicon oxide layer, polymide or other materials that are typically used in isolation layers. The solder pad 102 provides an electrical connection with the circuit fabricated in the wafer 100. The connection point 103 couples the solder pad 102 with the circuit in the active material such as silicon wafer 100. The process of fabricating interconnects 105 is well known in the art, therefore, further explanation is being omitted.

Going back to FIG. 1a, the wafer 100, after forming the solder pads 102 is laid backside up on the carrier 104. Note that in normal wafer fabrication techniques, the wafer 100 is processed from the front side (or the side on which the devices are fabricated is called the front side or active side). In the methods described here, the wafer 100 is processed from the backside, that is on the side opposite to the active side. It should be noted that a top insulation/protective layer 106 is formed on the active side to protect the devices. This protective layer 106 may be formed as a part of fabricating the solder pads 102 and/or as a part of fabricating the desired circuit., as described above.

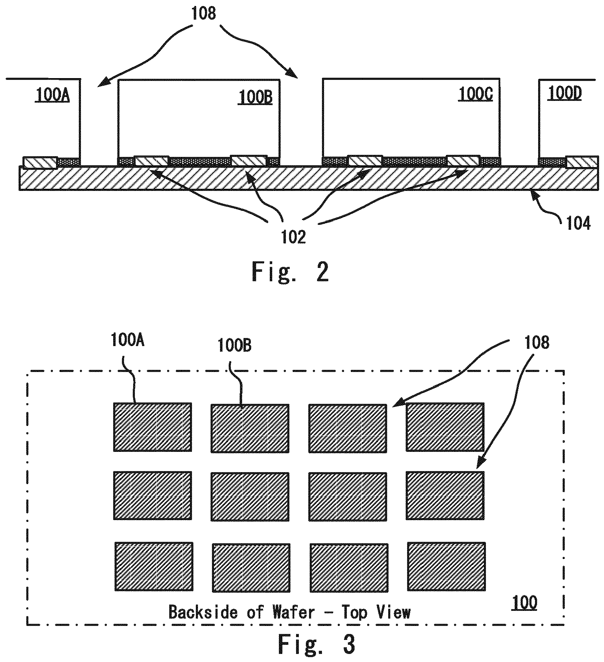

FIG. 2 illustrates a cross section of the wafer 100 after trenches 108 are formed in the backside of the wafer. In some embodiments, trenches 108 are between 50µm to 200µm wide. The trenches 108 are formed through the lithography and etching process, typically plasma etching but other types of etching such as reactive etching, physical etching, wet etching, etc. may also be employed. To perform plasma etch, the wafer 100 masked with photoresist is placed in a process chamber which is evacuated. A small amount of reactive gas is introduced into the process chamber. An electromagnetic field is then applied and the places on the wafer 100 backside that are not protected by the photoresist are etched away by the etchant gas. In some embodiments, reactive etching may also be used. Reactive etching is a technique that is a combination of physical and chemical etching. Reactive etching entails controlled energetic ion bombardment with chemically reactive interaction. Physical etching is the use of energetic particles to physically remove material. A beam of charged particles is used in the technique called ion milling. Ion milling is similar to reactive ion etching, except that it uses only the energy of motion of the ions to etch material. Note that two solder pads are being shown per device 100A...D for illustration purpose only. In practice, the number of solder pads 102 will depend on the type of circuit in the underlying device 100A... 100D.

The trenches 108 are fully or substantially go across the entire width of the wafer 100. In some embodiments, the protective layer 106 at the bottom of trenches 108 is also removed during the etching process. The location of trenches 108 may be the same as if devices 100A...D were to be cut by mechanical means after processing the wafer 100, as depicted by FIG. 3 that shows a plan view of a part of the backside of the wafer 100 showing scribe lanes 108 and remaining silicon blocks 100A, 100B after the trenches 108 are formed. In the embodiments in which the protective layer 106 is also removed under trenches 108, the white space shown in FIG. 3 is a view of the carrier 104 which becomes exposed after the trenches 108 are formed. Since the wafer 100 was securely placed on the carrier 104, the devices 100A...D stay stable after the trenches 108 are formed to remove the material between devices 100A...D.

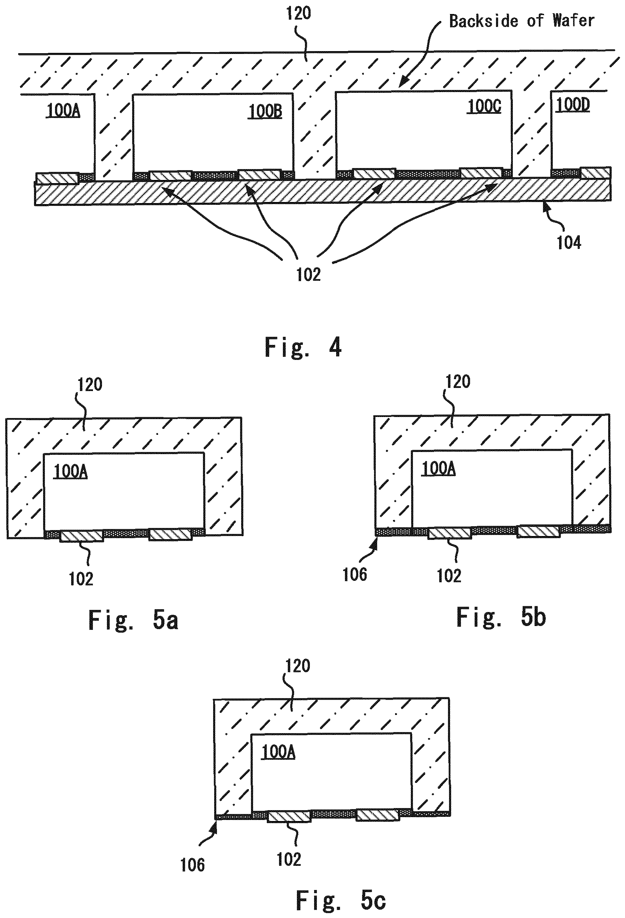

As shown in FIG. 4, the wafer 100 is then overmolded 120 using a molding compound at a desired temperature and pressure depending upon the type of material used as the molding compound. The molding compound is a low temperature polymer that has a lower temperature threshold than silicon so that a protective layer of the mold compound can be formed at a temperature that does not damage the underlying wafer or the devices fabricated on the wafer 100. The molding compound fills the trenches 108 and covers the entire backside of the wafer 100. Subsequently, individual devices 100A...D are cut out of the wafer 100 typically using mechanical cutting means. Other type of cutting tools may be employed so long as those tools are capable of cutting each device without damaging sidewalls covered with the protective layer 120 of the devices 100A...D. FIG. 5a depicts a device 100A after it is cut from the wafer 100. As shown the overmold 120 covers the device 100A on all sides except the active side around the solder pads 102. In some embodiments, as shown in FIG. 5B, the isolation layer 106 at the bottom of the trenches 108 is not removed during the formation of the trenches 108 through the process of etching. Further, as shown in FIG. 5c, in some embodiments, the isolation layer 106 at the bottom of the trenches 108 is partially removed. The thickness of the overmold 102 on the side of the device 100A may be in the range of 20µm to 150µm. In other embodiments, the thickness of the overmold 120 may depends on a type of application and end user requirements. In some embodiments, the overmold 120 may be mechanically grinded to reduce the thickness to a desired value as required by a particular application.

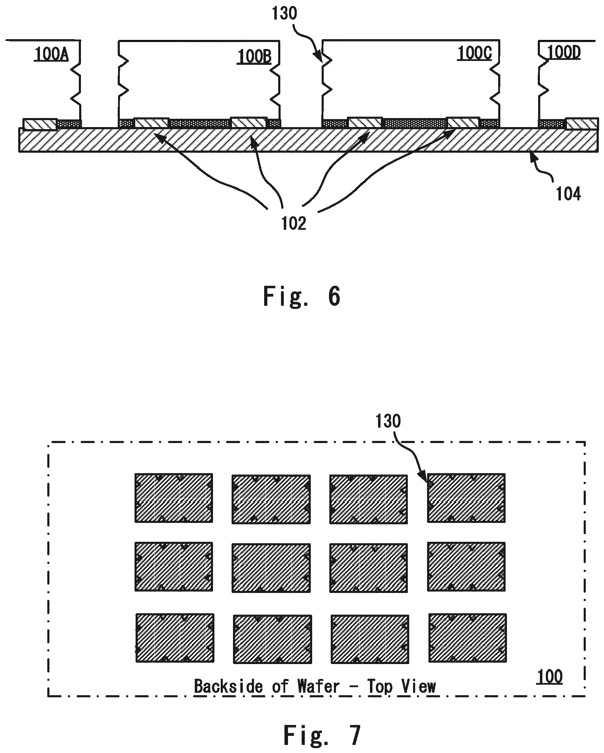

FIG. 7 depicts another embodiment in which during the lithography and etching process performed on the backside of the wafer 100, as described in FIG. 2, non-linear lines are used during lithography so that after the etching process, the sidewalls of each device are non-linear. FIG. 7 is a plan view of a section of the backside of the wafer 100 showing grooves in sidewalls. These grooves in the sidewalls provides a better adhesion when the overmold 120 layer is formed and trenches 108 are filled, as explained in FIG. 4.

Fig 6 depicts another embodiment in which during the etching process performed on the backside of the wafer 100, as described in FIG. 2, horizontal (to the wafer surface) grooves are produced during the etch process, so that the sidewalls of each device is non-planar. These grooves in the sidewalls provides a better adhesion when the overmold 120 layer is formed and trenches 108 are filled, as explained in FIG. 4.

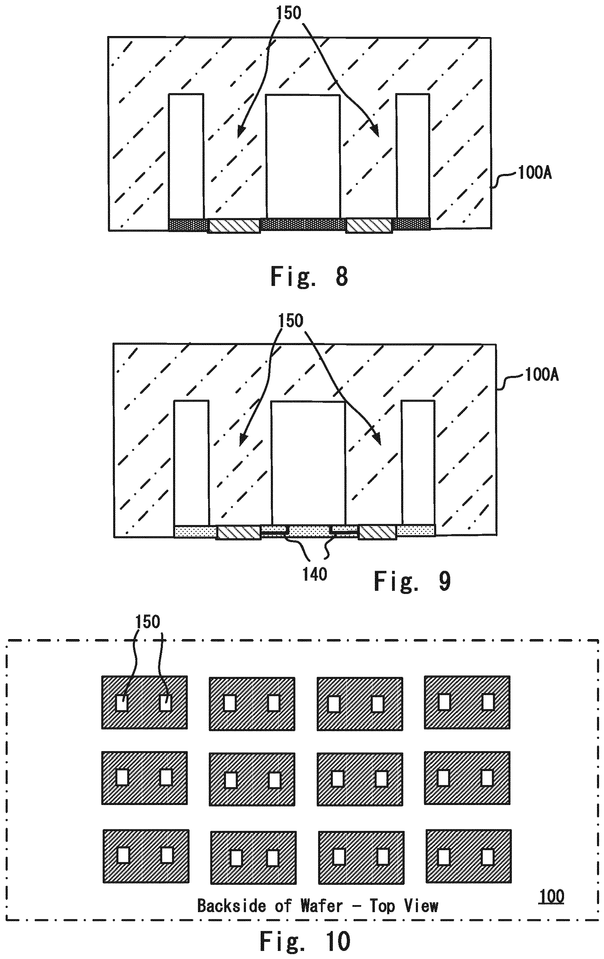

FIG. 8 depicts a device 100A in another embodiment in which the silicon or active material under the solder pads 102 is removed during the same lithography and etching process described in FIG. 2. At least in some embodiments, the isolation layer 106 under the solder pads 102 is not removed or it is only partially removed. In some other embodiments, the isolation layer 106 is removed under the solder pads 102 and subsequently replaced by the overmold compound layer. FIG. 10 shows the top view of a section of the backside of the wafer 100 after the lithography and etching process. As depicted, wells 150 are formed by etching away the active material from under the solder pads 102. Note that the lithography and etching process is not being described so as not to obfuscate the present disclosure and because these processes are well known in the art.

Removing active material from under the solder pads 102 is beneficial because doing so eliminates or at least greatly reduces the solder pad to silicon capacitance, which may be desirable in many applications such as ultralow capacitance electrostatic discharge devices (ESD). FIG. 9 shows the device 100A of FIG. 8 in another embodiment. As shown in FIG. 9, the solder pads 102 are connected with the active region through interconnect 140. Formation of interconnects is well known in the art, hence further explanation is being omitted. After forming the wells 150, the backside of the wafer 100 is overmolded as described in FIG. 4.

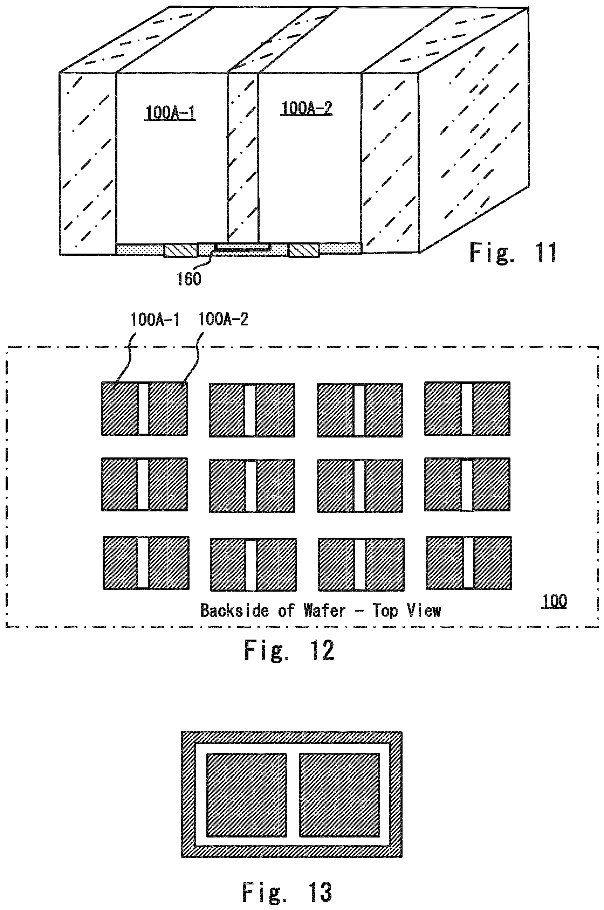

In another embodiment as depicted in FIG. 11 and FIG. 12, the active region may be sliced in the middle through the lithography and etching process during the trenches 108 formation thus providing electrical isolation between two sections 100A-1 and 100A-2 of the device 100A (same for other devices in the wafer 100). As noted earlier, figures depicts simplified structures to provide better understanding of the disclosure. For example, in practice, the number of solder pads 102 per device may vary and the number of isolation sections may be different based on the underlying circuit definition. This isolation may be beneficial in applications in which a device includes two circuit groups that may electrically interfere with each other or one may interfere with another. The two modules can be electrically connected via an interconnect 160. Note that the wells 150 depicted in previous figures may also be employed in this embodiment. FIG. 13 depicts the device 100A in another embodiment showing a different pattern of isolation regions. In this embodiment, the active material on the edges of the device 100A is not etched to provide greater mechanical stability. Note that other patterns of isolation regions based on the requirements of the underlying circuit definition are well within the scope of this disclosure.

Some or all of these embodiments may be combined, some may be omitted altogether, and additional process steps can be added while still achieving the products described herein. Thus, the subject matter described herein can be embodied in many different variations, and all such variations are contemplated to be within the scope of what is claimed.

While one or more implementations have been described by way of example and in terms of the specific embodiments, it is to be understood that one or more implementations are not limited to the disclosed embodiments. To the contrary, it is intended to cover various modifications and similar arrangements as would be apparent to those skilled in the art. Therefore, the scope of the appended claims should be accorded the broadest interpretation so as to encompass all such modifications and similar arrangements.

The use of the terms "a" and "an" and "the" and similar referents in the context of describing the subject matter (particularly in the context of the following claims) are to be construed to cover both the singular and the plural, unless otherwise indicated herein or clearly contradicted by context. Recitation of ranges of values herein are merely intended to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims as set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the invention as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A method of packing a semiconductor device, the method comprising:
placing a wafer on a carrier such that a backside of the wafer is facing up and a front side is facing down and non-permanently affixed to the surface of the carrier;
performing lithography to mark area to be etched on the backside of the wafer;
etching the marked areas from the backside of the wafer thus forming trenches that mark boundaries of individual devices on the wafer;
applying a protective coating on the backside of the wafer thus filling the trenches and entire backside of the wafer with a protective compound; and
cutting the individual devices from the wafer.

2. The method of claim 1, further including removing the individual devices from the carrier.

3. The method of claims 1 or 2, wherein the carrier includes a sticky foil and / or a buffer wafer.

4. The method of any preceding claim, wherein the front side of the wafer includes a solder pad.

5. The method of claim 4, wherein the front side of the wafer, except the solder pad, is covered with an isolation layer.

6. The method of claim 5, wherein the etching includes removing at least a portion of the isolation layer and / or creating grooves in the trenches, wherein the grooves are horizontal to surface of the wafer.

7. The method of any preceding claim, wherein the lithography to mark areas uses non-linear lines to mark the boundaries.

8. The method of claim 7, wherein the etching results in the individual devices with grooves on sidewalls.

9. The method of any preceding claim, wherein the protective coating uses a non-conductive material with adhesive characteristics.

10. The method of any preceding claim, wherein the lithography and the etching further includes marking and etching area under the solder pad.

11. The method of any preceding claim, wherein the lithography and the etching further includes dividing each of the individual devices into two or more active regions separated by a dividing trench.

12. The method of any preceding claim, wherein the applying the protective coating fills the area under the solder pad with the protective compound and / or wherein the applying the protective coating fills the dividing trench with the protective compound.

13. A semiconductor device packaged using an operation on a backside of a wafer, the operation comprising:
placing a wafer on a carrier such that a backside of the wafer is facing up and a front side is facing down and non-permanently affixed to the surface of the carrier;
performing lithography to mark area to be etched on the backside of the wafer;
etching the marked areas from the backside of the wafer thus forming trenches that mark boundaries of individual devices including the semiconductor device on the wafer;
applying a protective coating on the backside of the wafer thus filling the trenches and entire backside of the wafer with a protective compound; and
cutting the semiconductor device from the wafer.

14. The method of claim 13, wherein the carrier includes at least one of a sticky foil and a buffer wafer.

15. The method of claim 13 or 14, wherein the front side of the semiconductor device includes a solder pad and wherein the front side of the wafer, except the solder pad, is covered with an isolation layer.
